(19) Europäisches Patentamt / European Patent Office / Office européen des brevets

(11) **EP 1 630 817 B1**

(12) **EUROPÄISCHE PATENTSCHRIFT**

(45) Veröffentlichungstag und Bekanntmachung des Hinweises auf die Patenterteilung:
**12.11.2008 Patentblatt 2008/46**

(51) Int Cl.:
*G11C 11/00* (2006.01)     *G11C 16/02* (2006.01)

(21) Anmeldenummer: 05106903.7

(22) Anmeldetag: **27.07.2005**

(54) **Resistive Speicheranordnung, insbesondere CBRAM-Speicher**

Resistive memory device, in particular CBRAM memory

Dispositif de mémoire résistive, en particulier une mémoire CBRAM

(84) Benannte Vertragsstaaten:
**DE FR GB IT**

(30) Priorität: **30.08.2004 DE 102004041907**

(43) Veröffentlichungstag der Anmeldung:
**01.03.2006 Patentblatt 2006/09**

(73) Patentinhaber: **Qimonda AG**
**81739 München (DE)**

(72) Erfinder:
• **Liaw, Corvin**
  **81737 München (DE)**

• **Röhr, Thomas**
  **85609 Aschheim (DE)**
• **Kund, Michael**
  **83104 Tuntenhausen (DE)**

(74) Vertreter: **Kottmann, Heinz Dieter et al**
**Patentanwälte,**
**Müller . Hoffmann & Partner,**
**Innere Wiener Strasse 17**
**81667 München (DE)**

(56) Entgegenhaltungen:
DE-A1- 10 056 159     US-A- 5 761 115
US-A1- 2004 047 219     US-B1- 6 363 007

**Beschreibung**

Die Erfindung betrifft eine resistive Speicheranordnung mit einem in Reihen und Spalten gegliederten Zellenfeld aus resistiven Speicherzellen, insbesondere CBRAM-Widerstandselementen gemäß dem Oberbegriff des Patentanspruchs 1 sowie Verfahren zum Schreiben, Lesen und Löschen einer solchen resistiven Speicheranordnung. Eine mit dem Oberbegriff des Patentanspruchs 1 übereinstimmende resistive Speicheranordnung ist aus WO 03/098636 A2 bekannt.

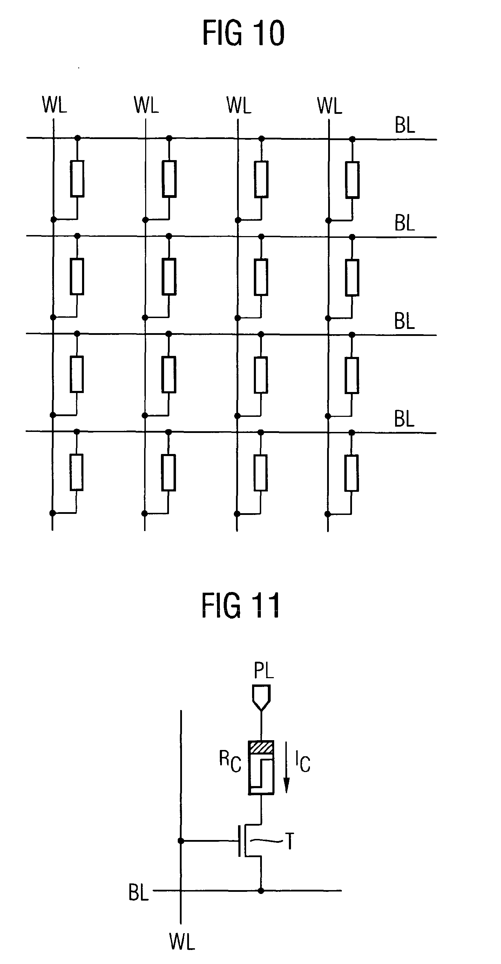

Bisher wurden die Speicherzellen einer resistiven Speicheranordnung entweder in Form eines Cross-Point-Arrays (vgl. beiliegende Fig. 10) oder in einer 1T1R-Anordnung (vgl. Fig. 11) gegliedert. Fig. 11 zeigt, dass jedem resistiven Speicherelement Rc genau ein Auswahl- oder Ansteuerelement T, in diesem Fall ein FET, zur Auswahl des Speicherelements zugeordnet ist. Bei dieser Schaltungsanordnung ist die Steuerelektrode des Ansteuertransistors T mit einer in Spaltenrichtung laufenden Wortleitung WL und eine gesteuerte Elektrode desselben mit einer in Zeilenrichtung laufenden Bitleitung BL verbunden. Die andere gesteuerte Elektrode des Ansteuertransistors T ist mit der einen Elektrode eines CBRAM-Widerstandselements Rc verbunden, dessen andere Elektrode an einer Plateleitung PL liegt.

WO 03/098636 A2 zeigt eine Möglichkeit, beide Schaltungsanordnungen zu kombinieren. Ein weiterer Vorschlag für MRAM-Speicher wird in WO 02/0844705 A2 dargelegt. Bei der in der letztgenannten Druckschrift beschriebenen Speicheranordnung sind alle Widerstandelemente nur mit einer Leitung beschaltet. Zur Adressierung der verschiedenen Widerstände werden die Schreibleitungen benützt. Nachteile der Cross-Point-Anordnung gemäß Fig. 10 sind die beschränkte Größe des Speicherfeldes, das komplizierte Auslesen der gespeicherten Werte und die damit verbundene Verzögerung des Auslesewerts. Die in Fig. 11 veranschaulichte 1T1R-Zelle kann schneller und unkomplizierter gelesen werden, doch ist ihr Platzbedarf höher. Ein erster Kompromiss ist die in WO 03/098636 A2 beschriebene Lösung, bei der kleinere Cross-Point-Anordnungen verschaltet werden (vertikal angeordnet). Dieser Kompromiss legt seinen Schwerpunkt auf den geringeren Platzbedarf, was auf Kosten der Geschwindigkeit geschieht. Die in WO 02/084705 A2 vorgeschlagene Lösung ist aufgrund zweier Lesezyklen langsam und, da eine Schreibleitung benutzt wird, nur für MRAM-Speicheranordnungen geeignet.

Aus US 2004/0047219 A1 ist ein nichtflüchtiger ferroelektrischer Halbleiterspeicher bekannt, bei dem die Speicherzellen eine 1TnR-Zellenstruktur haben, d.h. dass n-ferroelektrische Speicherkapazitäten einer Speicherzelle mit einem einzigen Auswahltransistor verbunden sind und die Steuerelektroden der Auswahltransistoren einer Spalte gemeinsam an einer in Spaltenrichtung laufende Wortleitung und die ersten gesteuerten Elektroden der Auswahltransistoren einer Zeile gemeinsam an eine in Zeilenrichtung laufende Bitleitung angeschlossen sind. Die zweiten gesteuerten Elektroden jedes Auswahltransistors sind jeweils mit den ersten Elektroden der n-ferroelektrischen Kapazitäten und die zweiten Elektroden der ferroelektrischen Speicherkapazitäten jeder Spalte einzeln jeweils mit einer in Spaltenrichtung laufenden Plateleitung verbunden.

Es ist Aufgabe der Erfindung, die oben erwähnten im Stand der Technik vorhandenen Nachteile der Cross-Point-Anordnung und der 1T1R-Anordnung zu vermeiden und die eingangs geschilderte resistive Speicheranordnung so zu verbessern, dass jede Speicherzelle derselben nur einen geringen Platzbedarf hat, einen schnellen Zugriff erlaubt und auf sie einwirkende Übersprech- und Störspannungen unschädlich gemacht sind.

Bei der vorliegenden Erfindung werden n Zellenwiderstände, die gemeinsam eine Speicherzelle bilden, mit einem Ansteuerelement, z. B. einem FET verbunden. Die Adressierung der verschiedenen Zellen erfolgt nun über die Wortleitungen, die die Ansteuertransistoren steuern, die Bitleitungen und die Plateleitungen, die nun für jedes Widerstandselement am Transistor separat ausgeführt sind.

Gemäß einem wesentlichen Aspekt wird die obige Aufgabe gelöst durch eine resistive Speicheranordnung mit einem in Reihen und Spalten gegliederten Zellenfeld aus Speicherzellen, die zur Ansteuerung mit einem Ansteuerelement verbunden sind, wobei jedes Ansteuerelement gemeinsam mit n eine Speicherzelle bildenden Zellenelementen verbunden ist, die Steuerelektroden der Ansteuerelemente einer Spalte gemeinsam an eine in Spaltenrichtung laufende Wortleitung und die ersten gesteuerten Elektroden der Ansteuerelemente einer Zeile gemeinsam an eine in Zeilenrichtung laufende Bitleitung angeschlossen sind, die zweiten gesteuerten Elektroden jedes Ansteuerelements jeweils mit den ersten Elektroden der n-Zellenelemente und die zweiten Elektroden der n-Zellenelemente jeder Spalte einzeln jeweils mit einer in Spaltenrichtung laufenden Plateleitung verbunden sind, dadurch gekennzeichnet, dass die Zellenelemente CBRAM-Widerstandselemente sind, und dass die Plateleitungen der CBRAM-Widerstandselemente an einem Ansteuerelement im Ruhezustand kurzgeschlossen sind.

Eine derartige Speicherzelle wird im Folgenden als 1TnR-Zelle bezeichnet.

Bevorzugt sind die Ansteuerelemente Feldeffekttransistoren.

Im Falle der eine unsymmetrische Charakteristik aufweisenden CBRAM-Widerstandselemente sind deren Anoden mit den Plateleitungen und deren Kathoden mit dem Ansteuerelement verbunden. Um Schreib- und Löschfehler zu vermeiden, kann jeweils eine Diode in Durchlass- oder Durchbruchrichtung in Serie zu den CBRAM-Widerstandselementen geschaltet sein.

Bei einem bevorzugten Ausführungsbeispiel enthält jede Speicherzelle n = 4 Zellenwiderstände.

Des Weiteren kann sich eine erfindungsgemäße Speicheranordnüng dadurch auszeichnen, dass ein ausgewähltes CBRAM-Widerstandselement jeder Speicherzellen in seinem hochohmigen Zustand durch Programmierung mit einem sich von den Programmierströmen, mit denen der hochohmige Zustand der restlichen CBRAM-Widerstandselemente derselben Speicherzelle programmiert ist, unterscheidenden Programmierstrom auf einen Widerstandswert programmiert ist, der niederohmiger ist als die jeweiligen Widerstandswerte im hochohmigen Zustand der restlichen CBRAM-Widerstandselemente derselben Speicherzelle.

Gemäß einem zweiten wesentlichen Aspekt gibt die Erfindung ein Verfahren zum Schreiben eines CBRAM-Widerstandselements einer derartigen resistiven Speicheranordnung an, das gekennzeichnet ist durch folgende Schritte:

S1: die Wortleitung der entsprechenden Speicherzelle wird geöffnet und alle Plateleitungen und Bitleitungen unselektierter Widerstandselemente werden auf ein bestimmtes Platepotenzial gelegt; und

S2: die Plateleitungsspannung des selektierten Widerstandselements wird um eine bestimmte Schreibspannung $\Delta V$write von annähernd 150 mV auf VPL + $\Delta V$write erhöht und die Spannung der dazu gehörigen Bitleitung um diese Schreibspannung auf VPL - $\Delta V$write abgesenkt.

Zum parallelen Schreiben mehrerer Widerstandselemente an der ausgewählten Plateleitung kann vorteilhafterweise die Bitleitungsspannung mehrerer Bitleitungen um die Schreibspannung $\Delta V$write abgesenkt werden.

Im Falle der in Serie zu den CBRAM-Widerstandselementen eingeschalteten Diode werden vorteilhafterweise die jeweils anzulegenden Spannungen je nach Polung der Diode um deren Durchlass- oder Durchbruchspannung erhöht.

Gemäß einem weiteren Aspekt gibt diese Erfindung ein Verfahren zum Löschen eines CBRAM-Widerstandselements einer resistiven Speicheranordnung an, das gekennzeichnet ist durch folgende Schritte:

E1: die der Speicherzelle mit dem zu löschenden Widerstandselement entsprechende Wortleitung wird geöffnet, und alle Plateleitungen und Bitleitungen unselektierter Widerstandselemente werden auf ein bestimmtes Platepotenzial gelegt; und

E2: die Plateleitungsspannung des selektierten Widerstandselements wird um eine bestimmte Löschspannung $\Delta V$erase auf VPL - $\Delta V$erase verringert und die Spannung der dazugehörigen Bitleitung um die Löschspannung auf VPL + $\Delta V$erase erhöht.

Im Falle des Einsatzes der Diode in Serie zu den CBRAM-Widerstandselementen werden die jeweils anzulegenden Spannungen je nach Polung der Diode um deren Durchlass- oder Durchbruchspannung erhöht.

Gemäß einem weiteren Aspekt gibt die Erfindung ein Verfahren zum parallelen Löschen aller mit einem Ansteuerelement verbundener Widerstandselemente entlang einer Wortleitung an, das durch folgende Schritte gekennzeichnet ist:

E11: die den Speicherzellen mit den zu löschenden Widerstandselementen entsprechenden Wortleitungen werden geöffnet und alle Plateleitungen und Bitleitungen unselektierter Widerstandselemente werden auf ein bestimmtes Platepotenzial gelegt und

E12: die Spannungen an den Plateleitungen der selektierten Zellen werden auf dem Plateleitungspotenzial gehalten und die Spannung an den Bitleitungen der selektierten Zellen um eine bestimmte Löschspannung erhöht.

Die obigen und weitere vorteilhafte Merkmale einer erfindungsgemäßen resistiven Speicheranordnung, eines Schreib-, Lese- und Löschverfahrens dafür und ein beispielhaftes Adressschema werden nachstehend anhand der Zeichnung näher erläutert. Die Zeichnungsfiguren zeigen im Einzelnen:

Fig. 1    ein Schaltschema einer beispielhaft vier CBRAMWiderstandselemente aufweisenden Zelle eines Zellenfeldes einer erfindungsgemäßen resistiven Speicheranordnung;

Fig. 2    graphisch eine Zellcharakteristik des CBRAMWiderstandselements;

Fig. 3    eine Schaltungsanordnung zur Erläuterung des erfindungsgemäßen Leseverfahrens;

Fig. 4    ein Layout eines ersten Ausführungsbeispiels einer resistiven Speicheranordnung gemäß der Erfindung mit vier Zellenwiderständen pro Ansteuertransistor;

Fig. 5    schematisch einen Querschnitt der in Fig. 4 in Layoutform gezeigten Speicheranordnung;

Fig. 6    im Querschnitt ein zweites Ausführungsbeispiel einer resistiven Speicheranordnung gemäß der Erfindung mit vier Zellenwiderständen pro Ansteuertransistor, bei dem zwei Möglichkeiten der Platzierung des Ansteuertransistors veranschaulicht sind;

Fig. 7    ein Schaltschema zur Erläuterung der kapazitiven Einkopplung von Störspannungen bei einem CBRAMWiderstandselement;

Fig. 8    schematisch einen Ausschnitt eines Zellenfeldes mit einem Pufferregister zur Erläuterung eines PageModus;

Fig. 9    ein Blockdiagramm zur Erläuterung eines Adressierpfads;

Fig. 10    die eingangs erläuterte Cross-Point-Array-Anordnung;

Fig. 11    die ebenfalls eingangs erläuterte 1T1R-Anordnung.

Bei der erfindungsgemäßen resistiven Speicheranordnung werden im Zellenfeld n Zellenwiderstände, die eine Speicherzelle bilden, mit einem Ansteuertransistor verbunden. Diese Anordnung wird nachstehend kurz 1TnR-Speicheranordnung genannt.

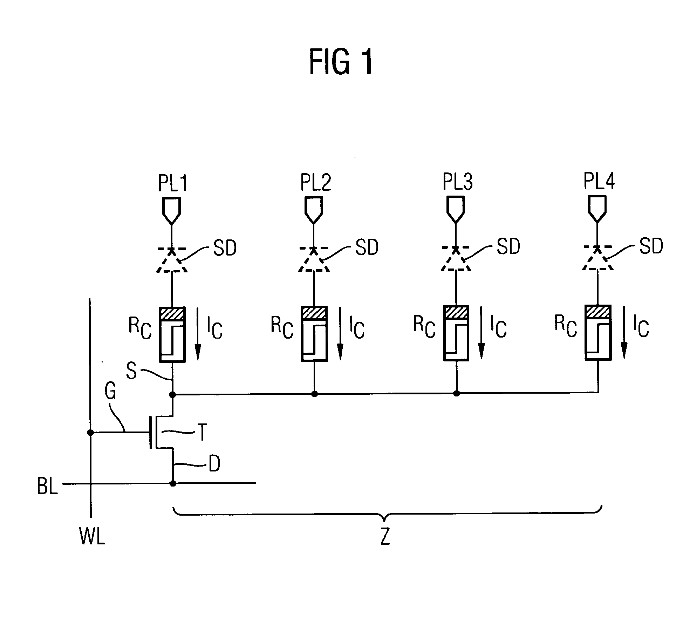

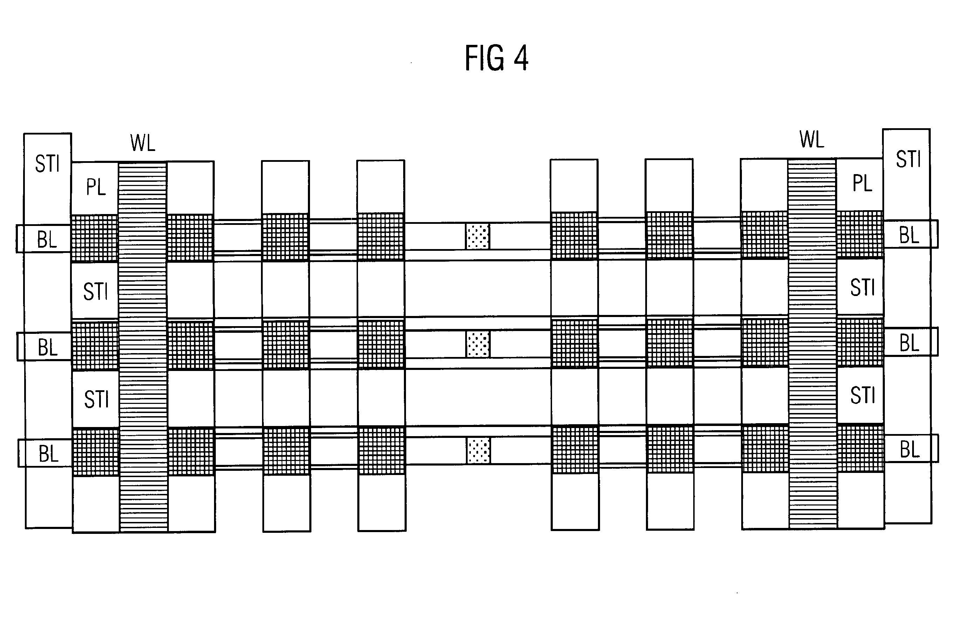

Fig. 1 zeigt ein bevorzugtes Ausführungsbeispiel einer resistiven Speicheranordnung, bei der vier CBRAM-Widerstandselemente Rc mit einem Feldeffekt-Ansteuertransistor T verbunden sind und eine 1T4R-Speicheranordnung bilden. Sinnvolle andere Anordnungen sind z. B. die 1T2R, die 1T8R, 1T16R-Speicheranordnungen. Die Anzahl n der mit dem einen Ansteuertransistor T verbundenen Zellenwiderstände Rc ist im Wesentlichen vom Adressierungs-, Schreib-, Lese- und Löschschema abhängig. Bei der in Fig. 1 gezeigten Speicheranordnung sind die Steuerelektroden G der Ansteuerelemente (Feldeffekttransistor) T einer Spalte gemeinsam an eine in Spaltenrichtung laufende Wortleitung WL und die ersten gesteuerten Elektroden D der Ansteuerelemente T einer Zeile gemeinsam an eine in Zeilenrichtung laufende Bitleitung BL angeschlossen und die zweiten gesteuerten Elektroden S jedes Ansteuerelements T sind jeweils mit den ersten Elektroden der n Zellenwiderstände Rc und die zweiten Elektroden der n Zellenwiderstände Rc jeder Spalte einzeln jeweils mit einer in Spaltenrichtung laufenden Plateleitung PL1 - PLn; PL11, PL12, PL13, PL14 verbunden. In vereinfachter Darstellung ist in Fig. 1 nur eine Zelle Z des gesamten Zellenfeldes gezeigt, das heißt diese Anordnung wiederholt sich entlang den in Spaltenrichtung laufenden parallelen Wortleitungen WL und den ebenfalls in Spaltenrichtung laufenden Plateleitungen PL. Ebenso wird die Anordnung in Zeilenrichtung entlang der Bitleitung BL fortgesetzt (siehe auch das Layout in Fig. 4). Die Adressierung der verschiedenen Zellen erfolgt über die Wortleitung WL, die den Ansteuertransistor T steuert, die Bitleitung BL und die Plateleitungen PL1 - PL4, die hier für jeden mit dem Transistor T verbundenen CBRAM-Widerstand Rc separat ausgeführt ist.

Die Funktionsweise wird im Folgenden anhand des unsymmetrischen CBRAM-Widerstands erläutert. In Fig. 1 manifestiert sich diese Unsymmetrie am speziellen Widerstandssymbol, bei dem die Anode auf der Seite des dicken Strichs liegt. Die Anordnung ist aber durchaus auch für Widerstände mit geeigneter symmetrischer Charakteristik verwendbar.

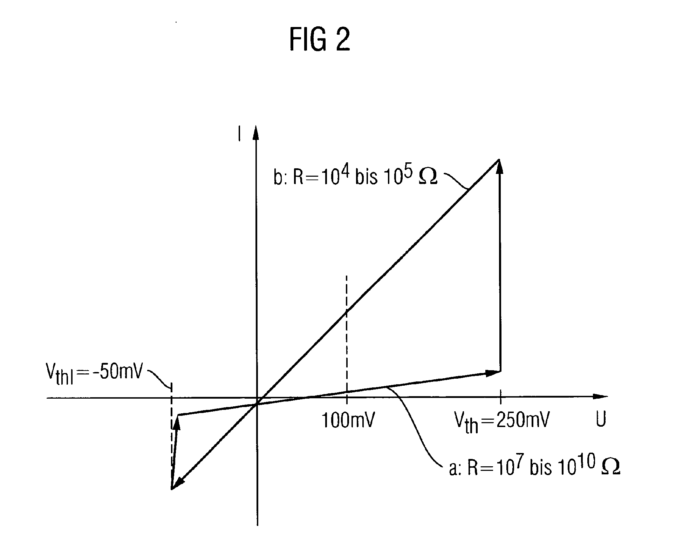

Die Kennlinien des CBRAM-Widerstandselements sind grafisch in Fig. 2 dargestellt. Der Widerstand ist ursprünglich hochohmig und beträgt je nach Ausführung $10^7$ bis $10^{10}$ Ω (Kennlinienast a). Wird die Spannung U in positiver Richtung erhöht (Anode am Pluspol und Kathode am Minuspol), schaltet der Widerstand ab einer Schreibschwellspannung Vth von annähernd 250 mV in den niederohmigen Zustand und hat dann annähernd $10^4$ bis $10^5$ Ω (Kennlinienast b). Bei negativer Spannung -U kann der Widerstand entsprechend Fig. 2 wieder in den hochohmigen Zustand gesetzt werden. Beim Lesen wird der Widerstand bei ca. 100 mV in positiver Richtung ausgewertet; in diesem Betriebszustand kann z. B. der Strom Ic durch das Widerstandselement Rc ausgewertet werden (vgl. Fig. 1).

Nachstehend wird ein Verfahren zum Schreiben eines CBRAM-Widerstandselements Rc einer 1TnR-Speicheranordnung, die damit verbundenen Probleme und Lösungsmöglichkeiten beschrieben. Um einen Widerstand zu schreiben, wird die Wortleitung WL der Zelle Z geöffnet. Alle Plateleitungen PL und Bitleitungen BL für unselektierte Widerstände sind auf dem Platepotenzial VPL. Um den ausgewählten Widerstand zu schreiben, wird dessen Plateleitung PL um ΔVwrite (Potenzial: VPL + ΔVwrite) erhöht und die dazugehörige Bitleitung BL um ΔVwrite abgesenkt (Potenzial VPL - ΔVwrite). Somit liegt an dem zu schreibenden Widerstand zweimal ΔVwrite an und an allen Widerständen der geöffneten Wortleitung WL ΔVwrite. Ist ΔVwrite gleich 150 mV, wird die selektierte Zelle mit einer Spannung von 300 mV geschrieben. Die restlichen Widerstände Rc behalten ihren ursprünglichen Wert, da die anliegende Spannung nicht zum Schreiben ausreicht. Werden mehrere Bitleitungen BL auf -ΔVwrite gelegt, können mehrere Widerstände Rc an der ausgewählten Plateleitung PL parallel geschrieben werden.

Besitzt die Schreibschwellspannung Vth eine Verteilung, das heißt, dass sie nicht nur einen einzelnen Wert (von z. B. 250 mV) hat, sondern z. B. Schwellspannungswerte zwischen Vthmax = 350 mV und Vthmin = 150 mV auftreten, kann es zu so genannten Write-Disturbs (Zellen, die nicht geschrieben werden sollen, werden geschrieben) oder zu so genannten "Write-Failures" kommen (zu schreibende Zellen werden nicht geschrieben, da die Spannung nicht ausreicht). Eine in Fig. 1 gestrichelt eingezeichnete Diode SD in Serie zu den Widerstandselementen Rc (in Durchlassrichtung oder Durchbruchrichtung gepolt) kann dieses Problem beseitigen, da die Bedingung 0,5 Vth > Vthmin nun auf die Schwellspannung der Diode D plus die Schreibspannung anzuwenden ist. Es gilt:

$$2 \text{ x } \Delta Vwrite > Vthmax + Vdiode$$

$$\Delta Vwrite < Vthmin + Vdiode$$

$$\text{Dies ergibt } Vdiode > Vthmax - Vthmin.$$

Je nachdem, wie die Dioden SD gepolt sind, müssen sie für Schreib- und Lese- oder für Löschoperationen im Durchbruch betrieben werden. Die anzulegenden Spannungen erhöhen sich dabei jeweils um die Diodenspannung (entweder Durchlassspannung oder Durchbruchspannung).

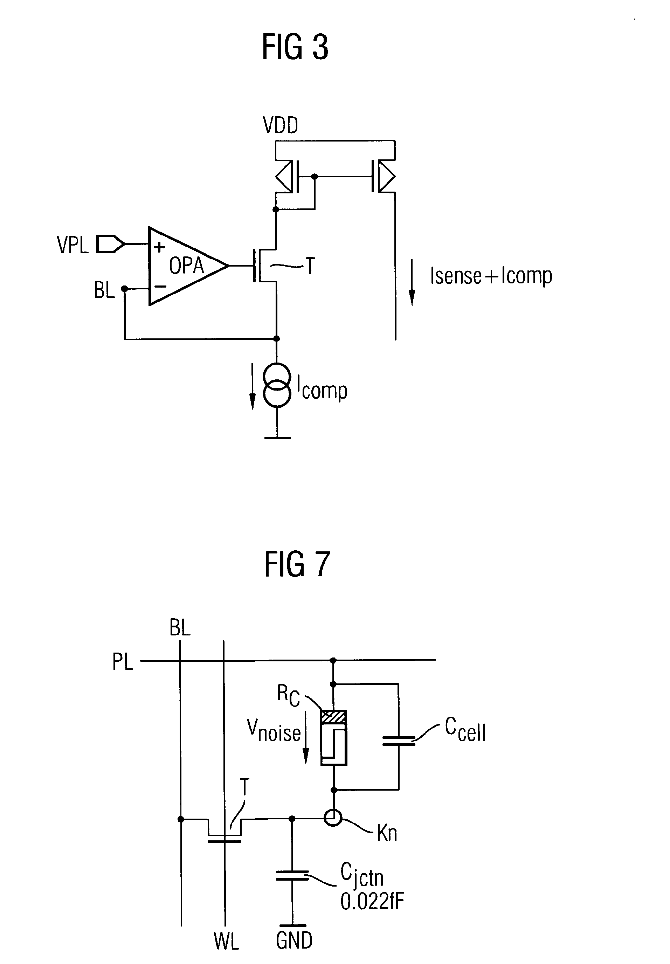

Weiterhin werden ein Verfahren zum Lesen eines CBRAM-Widerstandselements Rc, die dabei auftretenden Probleme und Lösungsmöglichkeiten dafür beschrieben. Beim Lesen eines CBRAM-Widerstands Rc wird die entsprechende Wortleitung WL der Zelle Z geöffnet. Mit einem Operationsverstärker OPA, wie er in Fig. 3 zu sehen ist, wird die Spannung der Bitleitung BL der selektierten Zelle Z auf Plateleitungspotenzial VPI gehalten. Wird nun die Plateleitung PL der zu lesenden Zelle auf eine Lesespannung Vread, eine Spannung um ca. 100 mV über der Plateleitungsspannung VPL gelegt, kann der Strom der Zelle gesenst werden (normales Current Sensing). Alle Plateleitungen PL und Bitleitungen BL nicht selektierter Widerstände sind dabei auf Plateleitungspotenzial VPL zu halten, um die parasitären Ströme zu minimieren. Da der Operationsverstärker OPA nicht genau auf VPL sondern auf einen Wert VPL +/- Voffset regelt, begrenzt der dadurch entstehende parasitäre Strom die Anzahl der Widerstandselemente Rc, die mit einem Ansteuertransistor T verbunden werden können. Werden mehrere Bitleitungen BL auf diese Weise mit einer Senseschaltung verbunden, so können parallel mehrere Widerstände gelesen werden. Diese Widerstände müssen aber an derselben Wortleitung WL und Plateleitung PL wie die restlichen gelesenen Widerstände liegen. Die restlichen Bitleitungen BL sollten, auch wenn sie nicht gelesen werden, auf VPL gehalten werden.

Weiterhin werden ein erfindungsgemäßes Verfahren zum Löschen von Widerständen, die dabei auftretenden Probleme und Lösungsmöglichkeiten beschrieben. Um ein einzelnes CBRAM-Widerstandselement zu löschen, muss über ihm die negative Löschschwellspannung Vthl von annähernd -50 mV angelegt werden (vgl. Fig. 2). Dazu wird die entsprechende Wortleitung WL geöffnet. Bei unselektierten Widerstandselementen Rc liegen die Bitleitung BL und Plateleitung PL auf Plateleitungspotenzial VPL. Ähnlich wie beim Schreiben werden nun Spannungen (nur diesmal mit umgekehrten Vorzeichen) angelegt. Die selektierte Plateleitung wird also auf VPL - ΔVerase und die Bitleitung auf VPL + ΔVerase gelegt. Wie beim Schreiben reicht die Spannung ΔVerase an den nicht selektierten Widerständen nicht aus, um diese zu löschen, während 2 x ΔVerase am selektierten Widerstandselement Rc genügt. Ebenso wie beim Schreiben kann es aufgrund einer Schwellspannungsverteilung zu Lösch-Disturbs und Lösch-Failures kommen. Neben der Möglichkeit, eine Diode SD einzusetzen (Fig. 1), kann auch ein so genannter Blockerase benützt werden, um Lösch-Disturbs und Lösch-Failures zu umgehen. Dabei werden alle mit einem Ansteuertransistor T verbundenen Widerstandselemente Rc (alle Zellen) entlang einer Wortleitung WL gelöscht. Vorteilhafterweise werden dann die Plateleitungen PL auf VPL gehalten und die entsprechenden Bitleitungen BL um den nötigen Spannungswert erhöht.

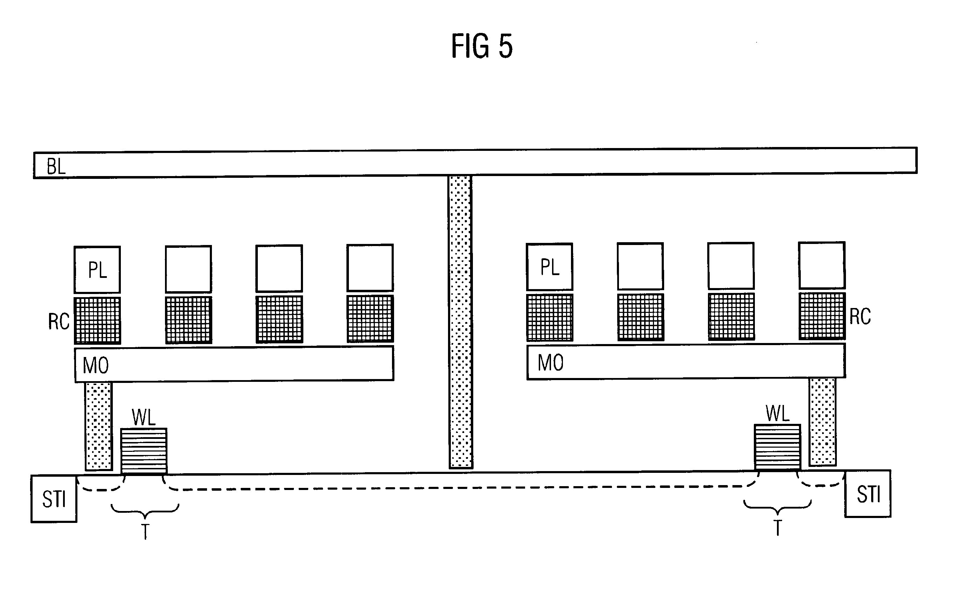

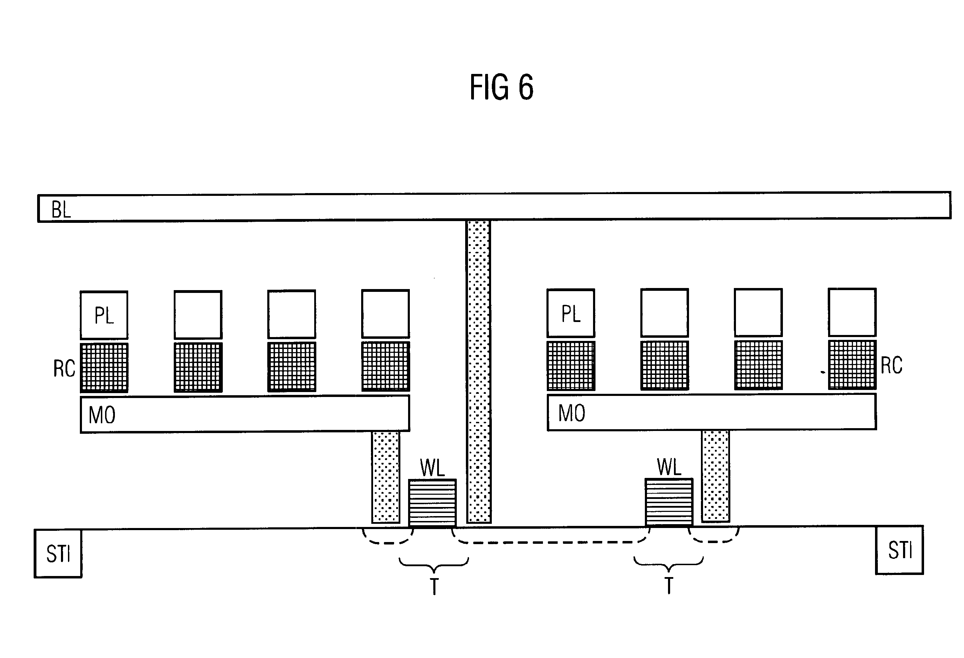

Fig. 4 zeigt schematisch ein Layout einer 1T4R-Speicheranordnung, und Fig. 5 zeigt dazu einen schematischen Querschnitt. Dieses Layout der 1T4R-Speicheranordnung ist symmetrisch zu mittig liegenden Bitleitungskontaktstöpseln zur Drainelektrode der Auswahltransistoren T. Die in den Fig. 4 und 5 gezeigte 1T4R-Anordnung ist lateral durch ein Shallow-Trench-Isolationsoxid STI von benachbarten 1T4R-Speicher-anordnungen isoliert. Fig. 6 zeigt im Querschnitt ein weiteres Ausführungsbeispiel einer (unsymmetrischen) 1T4R-Speicheranordnung, die zwei Möglichkeiten zeigt, den Ansteuertransistor T zu platzieren. Optimiert wird dabei entweder der Diffusionswiderstand (Fig. 6 links) oder die Symmetrie zu Metall M0 (Fig. 6 rechts).

Ein spezielles bei CBRAM-Widerstandselementen auftretendes Problem ist die Einkopplung von Störspannungen auf den Schaltungsknoten Kn zwischen einem (hochohmigem) Widerstandselement Rc und dem Ansteuertransistor T. Da im hochohmigen Zustand der Widerstand des CBRAM-Widerstandselements Rc bis zu $10^{10}$ Ω beträgt, ist im ausgeschalteten Zustand des Transistors T der Knoten Kn praktisch isoliert. Wie in Fig. 7 ersichtlich, können dann kapazitiv Störspannungen Vnoise auf den Knoten Kn gekoppelt werden. Diese Störspannungen können problematisch sein, da die Widerstandselemente aufgrund der niedrigen Schwellspannungen dadurch ungewollt programmiert oder gelöscht werden können. Um dies zu verhindern, ist die erfindungsgemäße 1TnR-Anordnung mit mehreren parallelen Widerstandselementen Rc aufgrund der Niederohmigkeit der Parallelschaltung vorteilhaft. Eine vorteilhafte Anordnung besteht darin, ein Widerstandelement der Speicherzelle speziell auf einen geeigneten niederohmigen Wert zu programmieren (bei CBRAM möglich durch Programmieren mit verschiedenen Strömen). Dies gleicht eine sich aufbauende Störspannung rasch aus, ohne einen Schreib- oder Löschdisturb zu verursachen. Die Plateleitungen PL der Widerstandselemente Rc an einem Ansteuertransistor T können im Ruhezustand z. B. kurzgeschlossen sein.

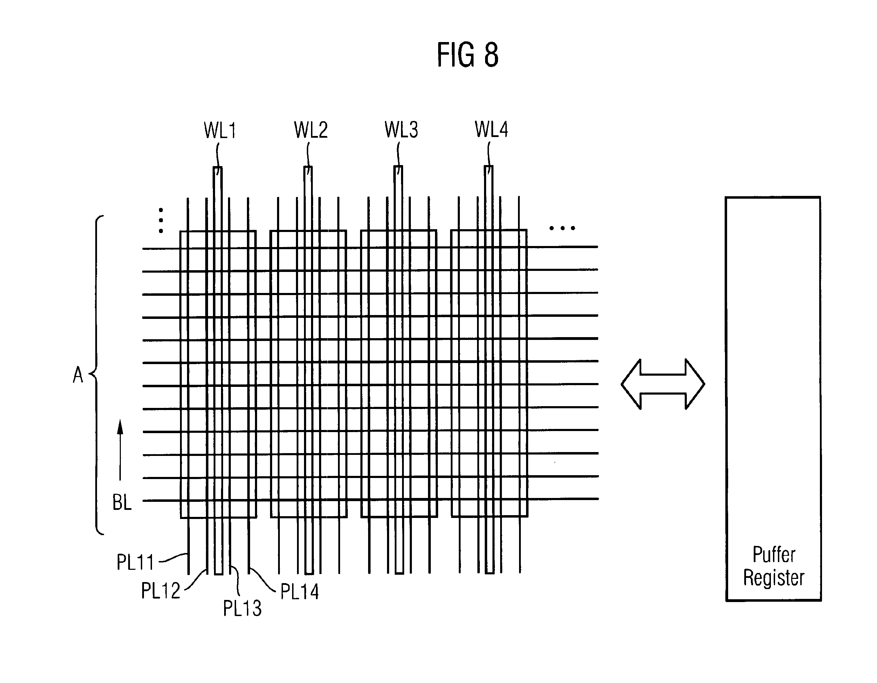

Ein vorteilhafter Modus, eine zuvor beschriebene 1TnR-Speicheranordnung zu betreiben, ist die verschiedenen Plateleitungen PL1, PLn (z. B. PL1 - PL4) einer Zelle Z mit einem Zähler nacheinander (jeweils eine Plateleitung parallel) zu lesen und in einem Pufferregister zuspeichern. Ein solcher Block kann dann als Page aufgefasst werden. Diese Page lässt sich vorteilhafterweise auch Plateleitung für Plateleitung beschreiben und auf einmal löschen (siehe das zuvor beschriebene Blocklöschverfahren). Dies erhöht die Geschwindigkeit der Vorgänge und die erzielbare Bandbreite, da immer nur wenige Leitungen umgeladen werden müssen. Ein Beispiel eines solchen Pagemodus ist schematisch in Fig. 8 dargestellt. Zum Beispiel wird in Fig. 8 die Wortleitung WL1 aktiviert, und ein Zähler steuert die Plateleitungen PL11 bis PL14 nacheinander an. Die Daten werden in einem Pufferregister zwischengespeichert und können als gesamte Page ausgegeben werden. In gleicher Weise wird eine Page geschrieben: die von außen kommenden Daten werden im Pufferregister zwischengespeichert. Nach dem Aktivieren der entsprechenden Wortleitung WL werden die Daten, z. B. beginnend mit Plateleitung PL11 geschrieben. Danach folgen PL12, PL13 und PL14. Gelöscht werden in diesem Modus alle Widerstandselemente, die sich an einer Wortleitung z. B. WL1 befinden. So kann z. B. die Wortleitung WL1 geöffnet werden. Die mit diesen Zellen verbundenen Plateleitungen PL11 bis PL14 befinden sich auf der Spannung VPL.

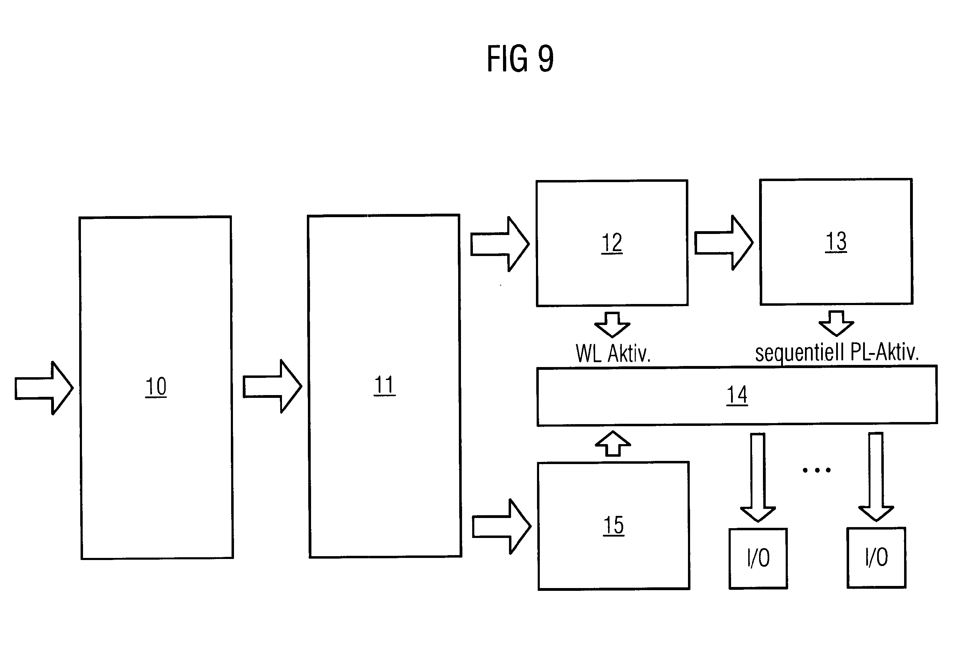

Fig. 9 zeigt in Form eines Blockschemas einen vorteilhaften Adresspfad für eine erfindungsgemäße resistive Speicheranordnung. Die Adresse in einem externen Adressen- und Befehlsregister 10 wird in einen Adressdecoder 11 geladen. Ein Wortleitungsdecoder 12 steuert die entsprechenden Wortleitungen WL und der Zähler 13 die Plateleitungen PL nacheinander an. Der Bitleitungsdecoder 15 steuert die richtigen Bitleitungen BL an, und die so gelesenen Daten werden in das dazugehörige Pufferregister 14 geladen. So kann ein größerer Burst über die I/O-Pads ausgelesen werden. Zum Schreiben wird die Richtung des Datenpfads einfach geändert, und die von den I/O-Pads kommenden Daten werden an den durch die in Fig. 9 gezeigte Adressierungslogik bestimmten Ort im Zellenfeld geschrieben.

Bemerkung: CBRAM ist eine bei der Anmelderin übliche Bezeichnung (CBRAM = Conductive Bridging RAM). In der Literatur wird oft die Bezeichnung PMC (Programmable Metallization Cell) benutzt.

Bezugszeichenliste

| a | hochohmiger Ast der CBRAM-Kennlinie |
| A | Zellenfeld |
| b | niederohmiger Ast der CBRAM-Kennlinie |
| BL | Bitleitung |
| Ccell | Zellkapazität |
| Cjtcn | Junctionkapazität |
| SD | Diode |
| D | Drain |
| G | Steuerelektrode |
| I/O | Ein/Ausgabepads |
| Ic | Strom durch ein CBRAM-Widerstandselement Rc |
| Ikomp | Kompensationsstrom |
| Isense | Sensestrom |
| Kn | Schaltungsknoten |
| M0 | Metallebene 0 |
| OPA | Operationsverstärker |
| PL | Plateleitung |
| Rc | Zellenwiderstand; CBRAM-Widerstandselement |
| S | Source |
| STI | Shallow-Trench-Isolation |
| T | Ansteuerelement; Ansteuertransistor |
| VDD | Betriebsspannung |
| Vnoise | Störspannung |
| VPL | Plateleitungsspannung/potenzial |
| WL | Wortleitung |

| 10 | externe Adressier- und Befehlseinheit |
|---|---|
| 11 | Adressendecoder |
| 12 | Wortleitungsdecoder |
| 13 | Zähler |
| 14 | Pufferregister |
| 15 | Bitleitungsdecoder |

**Patentansprüche**

1. Resistive Speicheranordnung mit einem in Reihen und Spalten gegliederten Zellenfeld (A) aus Speicherzellen, die zur Ansteuerung mit einem Ansteuerelement (T) verbunden sind, wobei

   - jedes Ansteuerelement (T) gemeinsam mit n eine Speicherzelle (Z) bildenden Zellenelementen (Rc) verbunden ist,
   - die Steuerelektroden (G) der Ansteuerelemente (T) einer Spalte gemeinsam an eine in Spaltenrichtung laufende Wortleitung (WL) und die ersten gesteuerten Elektroden (D) der Ansteuerelemente (T) einer Zeile gemeinsam an eine in Zeilenrichtung laufende Bitleitung (BL) angeschlossen sind,
   - die zweiten gesteuerten Elektroden (S) jedes Ansteuerelements (T) jeweils mit den ersten Elektroden der n-Zellenelemente (Rc) und die zweiten Elektroden der n-Zellenelemente (Rc) jeder Spalte einzeln jeweils mit einer in Spaltenrichtung laufenden Plateleitung (PL) verbunden sind,

   **dadurch gekennzeichnet,**
   **dass** die Zellenelemente (Rc) CBRAM-Widerstandselemente sind, und
   **dass** die Plateleitungen (PL) der CBRAM-Widerstandselemente an einem Ansteuerelement (T) im Ruhezustand kurzgeschlossen sind.

2. Speicheranordnung nach Anspruch 1,
   **dadurch gekennzeichnet,**
   **dass** die Ansteuerelemente (T) Feldeffekttransistoren sind.

3. Speicheranordnung nach Anspruch 1,
   **dadurch gekennzeichnet,**
   **dass** die Anoden der CBRAM-Widerstandselemente (Rc) mit den Plateleitungen (PL) und die Kathoden der CBRAM-Widerstandselemente (Rc) mit dem Ansteuerelement (T) verbunden sind.

4. Speicheranordnung nach Anspruch 3,
   **dadurch gekennzeichnet,**
   **dass** jeweils eine Diode (SD) in Durchlass- oder in Durchbruchrichtung in Serie zu den CBRAM-Widerstandselementen (Rc) geschaltet ist.

5. Speicheranordnung nach einem der Ansprüche 1 bis 4,
   **dadurch gekennzeichnet,**
   **dass** ein ausgewähltes CBRAM-Widerstandselement (Rc) jeder Speicherzellen (Z) in seinem hochohmigen Zustand durch Programmierung mit einem sich von den Programmierströmen, mit denen der hochohmige Zustand der restlichen CBRAM-Widerstandselemente derselben Speicherzelle (Z) programmiert ist, unterscheidenden Programmierstrom auf einen Widerstandswert programmiert ist, der niederohmiger ist als die jeweiligen Widerstandswerte im hochohmigen Zustand der restlichen CBRAM-Widerstandselemente (Rc) derselben Speicherzelle (Z).

6. Speicheranordnung nach einem der Ansprüche 1 bis 5,
   **dadurch gekennzeichnet,**
   **dass** jede Speicherzelle (Z) n = 4 Zellenwiderstände (Rc) enthält.

7. Verfahren zum Schreiben eines CBRAM-Widerstandselements (Rc) einer resistiven Speicheranordnung nach einem der Ansprüche 1 bis 6,
   **gekennzeichnet durch** folgende Schritte:

   S1: die Wortleitung (WL) der entsprechenden Speicherzelle (Z) wird geöffnet, und alle Plateleitungen (PL) und Bitleitungen (BL) unselektierter Widerstandselemente (Rc) werden auf ein bestimmtes Platepotenzial (VPL) gelegt; und

S2: die Plateleitungsspannung des selektierten Widerstandselements (Rc) wird um eine bestimmte Schreibspannung (ΔVwrite) erhöht und die Spannung der dazu gehörigen Bitleitung (BL) um dieselbe Schreibspannung abgesenkt.

8. Schreibverfahren nach Anspruch 7,
**dadurch gekennzeichnet,**
**dass** zum parallelen Schreiben mehrerer Widerstandselemente (Rc) an der ausgewählten Plateleitung (PL) die Bitleitungsspannung mehrerer Bitleitungen (BL) um die Schreibspannung (ΔVwrite) abgesenkt wird.

9. Schreibverfahren nach Anspruch 7 oder 8,
**dadurch gekennzeichnet,**
**dass** beim Einsatz der Diode (SD) in Serie zu den CBRAM-Widerstandselementen (Rc) die jeweils anzulegenden Spannungen je nach Polung der Diode (SD) um deren Durchlass- oder Durchbruchspannung erhöht werden.

10. Verfahren zum Löschen eines CBRAM-Widerstandselements (Rc) einer resistiven Speicheranordnung nach einem der Ansprüche 1 bis 6,
**gekennzeichnet durch** folgende Schritte:

E1: die der Speicherzelle (Z) mit dem zu löschenden Widerstandselement (Rc) entsprechende Wortleitung (WL) wird geöffnet, und alle Plateleitungen (PL) und Bitleitungen (BL) unselektierter Widerstandselemente (Rc) werden auf ein bestimmtes Platepotenzial (VPL) gelegt; und

E2: die Spannung an der Plateleitung (PL) des selektierten Widerstandselements (Rc) wird um eine bestimmte Löschspannung (ΔVerase) verringert und die Spannung der dazugehörigen Bitleitung (BL) um dieselbe Löschspannung (ΔVerase) erhöht.

11. Löschverfahren nach Anspruch 10,
**dadurch gekennzeichnet,**
**dass** bei Verwendung der Diode (SD) in Serie zu den Widerstandselementen (Rc) die jeweils anzulegenden Spannungen je nach Polung der Dioden (SD) um deren Durchlass- oder Durchbruchspannung erhöht werden.

12. Verfahren zum Betrieb einer resistiven Speicheranordnung nach einem der Ansprüche 1 bis 6,
**dadurch gekennzeichnet,**
**dass** eine Wortleitung (WL) einer Spalte aktiviert und die mit den Zellenwiderständen (Rc) der resistiven Speicherzellen (Z) verbundenen Plateleitungen dieser Spalte mit einem Zähler nacheinander angesteuert werden,
**dass** beim Lesevorgang die Information der nacheinander angesteuerten Zellenwiderstände (Rc) der Speicherzellen (Z) dieser Spalte über die Bitleitungen (BL) ausgelesen und in einem Pufferregister (14) zwischengespeichert und als gesamte Page ausgegeben werden, und
**dass** beim Schreibvorgang von außen kommende Schreibdaten einer Page im Pufferregister (14) zwischengespeichert, die entsprechende Wortleitung (WL) einer Spalte aktiviert und die im Pufferregister (14) zwischengespeicherten Schreibdaten sequentiell beginnend mit der ersten Plateleitung (PL1) bis zur letzten Plateleitung (PLn) den Zellenwiderständen (Rc) der Speicherzellen (Z) dieser Spalte eingeschrieben werden.

13. Verfahren zum parallelen Löschen aller mit einem Ansteuerelement (T) verbundener Widerstandselemente (Rc) entlang einer Wortleitung (WL) bei einer resistiven Speicheranordnung nach einem der Ansprüche 1 bis 6,
**gekennzeichnet durch** folgende Schritte:

E11: die den Speicherzellen (Z) mit den zu löschenden Widerstandselementen (Rc) entsprechenden Wortleitungen (WL) werden geöffnet, und alle Plateleitungen (PL) und Bitleitungen (BL) unselektierter Widerstandselemente (Rc) werden auf ein bestimmtes Platepotenzial (VPL) gelegt und

E12: die Spannungen an den Plateleitungen (PL) der selektierten Speicherzellen werden auf dem Platepotenzial (VPL) gehalten und die Spannung an den entsprechenden Bitleitungen (BL) um eine bestimmte Löschspannung (ΔVerase) erhöht.

**Claims**

1. Resistive memory arrangement having a cell array (A) structured in rows and columns and comprising memory cells connected to a drive element (T) for driving,

   - each drive element (T) jointly being connected to n cell elements (Rc) forming a memory cell (Z),
   - the control electrodes (G) of the drive elements (T) of a column are jointly connected to a word line (WL) running in the column direction and the first controlled electrodes (D) of the drive elements (T) of a row are jointly connected to a bit line (BL) running in the row direction,
   - the second controlled electrodes (S) of each drive element (T) are in each case connected to the first electrodes of the n cell elements (Rc) and the second electrodes of the n cell elements (Rc) of each column are individually connected in each case to a plate line (PL) running in the column direction,

   **characterized**
   **in that** the cell elements (Rc) are CBRAM resistance elements, and
   **in that** the plate lines (PL) of the CBRAM resistance elements at a drive element (T) are short-circuited in the quiescent state.

2. Memory arrangement according to Claim 1,
   **characterized**
   **in that** the drive elements (T) are field-effect transistors.

3. Memory arrangement according to Claim 1,
   **characterized**
   **in that** the anodes of the CBRAM resistance elements (Rc) are connected to the plate lines (PL) and the cathodes of the CBRAM resistance elements (Rc) are connected to the drive element (T).

4. Memory arrangement according to Claim 3,
   **characterized**
   **in that** a diode (SD) is in each case connected in the forward direction or in the breakdown direction in series with the CBRAM resistance elements (Rc).

5. Memory arrangement according to one of Claims 1 to 4,
   **characterized**
   **in that** a selected CBRAM resistance element (Rc) of each memory cell (Z), in its high-resistance state, is programmed by programming with a programming current, which differs from the programming currents with which the high-resistance state of the remaining CBRAM resistance elements of the same memory cell (Z) is programmed, to a resistance value having a lower resistance than the respective resistance values in the high-resistance state of the remaining CBRAM resistance elements (Rc) of the same memory cell (Z).

6. Memory arrangement according to one of Claims 1 to 5,
   **characterized**
   **in that** each memory cell (Z) contains n = 4 cell resistors (Rc).

7. Method for writing to a CBRAM resistance element (Rc) of a resistive memory arrangement according to one of Claims 1 to 6,
   **characterized by** the following steps:

   S1: the word line (WL) of the corresponding memory cell (Z) is opened, and all plate lines (PL) and bit lines (BL) of unselected resistance elements (Rc) are put at a specific plate potential (VPL); and
   S2: the plate line voltage of the selected resistance element (Rc) is increased by a specific write voltage ($\Delta$Vwrite) and the voltage of the associated bit line (BL) is decreased by the same write voltage.

8. Writing method according to Claim 7,
   **characterized**
   **in that**, for parallel writing to a plurality of resistance elements (Rc) on the selected plate line (PL), the bit line voltage of a plurality of bit lines (BL) is decreased by the write voltage ($\Delta$Vwrite).

9. Writing method according to Claim 7 or 8,
**characterized**
**in that**, in the case where the diode (SD) is used in series with the CBRAM resistance elements (Rc), the respective voltages to be applied are increased, depending on the polarity of the diode (SD), by the forward or breakdown voltage thereof.

10. Method for erasing a CBRAM resistance element (Rc) of a resistive memory arrangement according to one of Claims 1 to 6,
**characterized by** the following steps:

E1: the word line (WL) corresponding to the memory cell (Z) with the resistance element (Rc) to be erased is opened, and all plate lines (PL) and bit lines (BL) of unselected resistance elements (Rc) are put at a specific plate potential (VPL); and
E2: the voltage on the plate line (PL) of the selected resistance element (Rc) is reduced by a specific erase voltage ($\Delta$Verase) and the voltage of the associated bit line (BL) is increased by the same erase voltage ($\Delta$Verase).

11. Erasing method according to Claim 10,
**characterized**
**in that**, in the case where the diode (SD) is used in series with the resistance elements (Rc), the respective voltages to be applied are increased, depending on the polarity of the diodes (SD), by the forward or breakdown voltage thereof.

12. Method for operating a resistive memory arrangement according to one of Claims 1 to 6,
**characterized**
**in that** a word line (WL) of a column is activated and the plate lines of this column which are connected to the cell resistors (Rc) of the resistive memory cells (Z) are driven successively by means of a counter,
**in that**, during the reading process, the information of the successively driven cell resistors (Rc) of the memory cells (Z) of this column is read out via the bit lines (BL) and buffer-stored in a buffer register (14) and output as an entire page, and
**in that**, during the writing process, externally arriving write data of a page are buffer-stored in the buffer register (14), the corresponding word line (WL) of a column is activated and the write data buffer-stored in the buffer register (14) are written sequentially, beginning with the first plate line (PL1) up to the last plate line (PLn), to the cell resistors (Rc) of the memory cells (Z) of this column.

13. Method for parallel erasure of all resistance elements (Rc) connected to a drive element (T) along a word line (WL) in a resistive memory arrangement according to one of Claims 1 to 6,
**characterized by** the following steps:

E11: the word lines (WL) corresponding to the memory cells (Z) with the resistance elements (Rc) to be erased are opened, and all plate lines (PL) and bit lines (BL) of unselected resistance elements (Rc) are put at a specific plate potential (VPL), and
E12: the voltages on the plate lines (PL) of the selected memory cells are held at the plate potential (VPL) and the voltage on the corresponding bit lines (BL) is increased by a specific erase voltage ($\Delta$Verase).

**Revendications**

1. Dispositif de mémoire résistif comprenant un champ (A) composé de cellules de mémoire subdivisées en lignes et en colonnes qui pour la commande, sont reliées à un élément (T) de commande, dans lequel

- chaque élément (T) de commande est relié conjointement à n éléments (Rc) de cellules formant une cellule (Z) de mémoire,
- les électrodes (G) de commande des éléments (T) de commande d'une colonne sont raccordées conjointement à une ligne (WL) de mot s'étendant dans la direction des colonnes et les premières électrodes (D) commandées des éléments (T) de commande d'une ligne sont raccordées conjointement à une ligne (BL) de bit s'étendant dans la direction des lignes,
- les deuxièmes électrodes (S) commandées de chaque élément (T) de commande sont reliées, respectivement, aux premières électrodes des n éléments (Rc) de cellules et les deuxièmes électrodes des n éléments (Rc) de cellules de chaque colonne sont reliées individuellement respectivement à une ligne (PL) de plaque s'étendant dans la direction des colonnes,

**caractérisé**
**en ce que** les éléments (Rc) de cellules sont des éléments de résistance CBRAM et
**en ce que** les lignes (PL) de plaque des éléments de résistance CBRAM sont court-circuitées à l'état de repos sur un élément (T) de commande.

2.  Dispositif de mémoire suivant la revendication 1,
    **caractérisé**
    **en ce que** les éléments (T) de commande sont des transistors à effet de champ.

3.  Dispositif de mémoire suivant la revendication 1,
    **caractérisé**
    **en ce que** les anodes des éléments (Rc) de résistance CBRAM sont reliées aux lignes (PL) de plaque et les cathodes des éléments (Rc) de résistance CBRAM sont reliées à l'élément (T) de commande.

4.  Dispositif de mémoire suivant la revendication 3,
    **caractérisé**
    **en ce que**, respectivement, une diode (SD) est montée dans le sens passant ou dans le sens inverse en série avec les éléments (Rc) de résistance CBRAM.

5.  Dispositif de mémoire suivant l'une des revendications 1 à 4,
    **caractérisé**
    **en ce qu'**un élément (Rc) de résistance CBRAM sélectionné de chaque cellule (Z) de mémoire est programmé dans son état à grande valeur ohmique par programmation par un courant de programmation différent des courants de programmation, par lesquels l'état à grande valeur ohmique des éléments de résistance CBRAM restants de la même cellule (Z) de mémoire est programmé, jusqu'à une valeur de résistance qui est plus petite que les valeurs de résistance respectives à l'état à grande valeur ohmique des éléments (Rc) de résistance CBRAM restants de la même cellule (Z) de mémoire.

6.  Dispositif de mémoire suivant l'une des revendications 1 à 5,
    **caractérisé**
    **en ce que** chaque cellule (Z) de mémoire comporte n = 4 résistances (Rc) de cellules.

7.  Procédé pour écrire dans un élément (Rc) de résistance CBRAM d'un dispositif de mémoire résistif suivant l'une des revendications 1 à 6,
    **caractérisé par** les stades suivants :

    S1 la ligne (WL) de mot de la cellule (Z) de mémoire correspondante est ouverte et toutes les lignes (PL) de plaque et les lignes (BL) de bit d'éléments (Rc) de résistance non sélectionnées sont mises à un potentiel (VPL) de plaque déterminé ; et
    S2 : la tension de ligne de plaque de l'élément (Rc) de résistance sélectionné est élevée d'une tension (ΔVwrite) d'écriture déterminée et la tension de la ligne (BL) de bit qui y est associée est abaissée de la même tension d'écriture.

8.  Procédé d'écriture suivant la revendication 7,
    **caractérisé**
    **en ce que** pour écrire en parallèle dans plusieurs éléments (Rc) de résistance sur la ligne (PL) de plaque sélectionnée on abaisse la tension de ligne de bit de plusieurs lignes (BL) de bit sur la tension (ΔVwrite) d'écriture.

9.  Procédé d'écriture suivant la revendication 7 ou 8,
    **caractérisé**
    **en ce que**, lorsque l'on utilise la diode (SD) en série avec les éléments (Rc) de résistance CBRAM on élève les tensions appliquées respectivement suivant la polarisation de la diode (SD) de leur tension à l'état passant ou en sens inverse.

10. Procédé pour effacer un élément (Rc) de résistance CBRAM d'un dispositif de mémoire résistif suivant l'une des revendications 1 à 6,
**caractérisé par** les stades suivants :

E1: la ligne (WL) de mot correspondant à la cellule (Z) de mémoire ayant l'élément (Rc) de résistance à effacer est ouverte et toutes les lignes (PL) de plaque et lignes (BL) de bit des éléments (Rc) de résistance non sélectionnés sont mises à un potentiel (VPL) de plaque déterminé ; et

E2 : la tension sur la ligne (PL) de plaque de l'élément (Rc) de résistance sélectionné est abaissée d'une tension (ΔVerase) d'effacement déterminée et la tension de la ligne (BL) de bit associée est élevée de la même tension (ΔVerase) d'effacement.

**11.** Procédé d'effacement suivant la revendication 10,
**caractérisé en ce que**,
lorsque l'on utilise la diode (SD) en série avec les éléments (Rc) de résistance, les tensions appliquées respectivement sont élevées suivant la polarisation de la diode (SD) de sa tension dans le sens passant ou dans le sens inverse.

**12.** Procédé pour faire fonctionner un dispositif de mémoire résistif suivant l'une des revendications 1 à 6,
**caractérisé**
**en ce qu'**une ligne (WL) de mot active une colonne et les lignes de plaque, reliées aux résistances (Rc) de cellules des cellules (Z) de mémoire résistives, de cette colonne sont commandées les unes après les autres par un compteur,
**en ce que**, lors de l'opération de lecture, l'information des résistances (Rc) de cellules, commandées les unes après les autres, de cellules (Z) de mémoire de cette colonne est lue par les lignes (BL) de bit et est mémorisée intermédiairement dans un registre (14) tampon et est sortie sous la forme d'une page d'ensemble et
**en ce que**, lors de l'opération d'écriture, des données d'écriture d'une page venant de l'extérieur sont mémorisées intermédiairement dans le registre (14) tampon, la ligne (WL) de mot correspondante d'une colonne est activée et les données d'écriture mémorisées intermédiairement dans le registre (14) tampon sont écrites séquentiellement, en commençant par la première ligne (PL1) de plaque et en allant jusqu'à la dernière ligne (PLn) de plaque, dans les résistances (Rc) des cellules (Z) de mémoire de cette colonne.

**13.** Procédé d'effacement en parallèle de tous les éléments (Rc) de résistance reliés à un élément (T) de commande le long d'une ligne (WL) de mot dans un dispositif de mémoire résistif suivant l'une des revendications 1 à 6,
**caractérisé par** les stades suivants :

E11: les lignes (WL) de mot correspondant aux cellules (Z) de mémoire ayant les éléments (Rc) de résistance à effacer et toutes les lignes (PL) de plaque et lignes (BL) de bit des éléments (Rc) de résistance non sélectionnés sont mises à un potentiel (VPL) de plaque déterminé et

E12 : les tensions sur les lignes (PL) de plaque des cellules de mémoire sélectionnées sont maintenues au potentiel (VPL) de plaque et la tension sur les lignes (BL) de bit correspondantes est élevée d'une tension (ΔVerase) d'effacement déterminée.

# FIG 1

FIG 2

$b: R = 10^4$ bis $10^5 \; \Omega$

$V_{thl} = -50mV$

100mV

$V_{th} = 250mV$

U

$a: R = 10^7$ bis $10^{10} \; \Omega$

## FIG 3

VDD

VPL

+

OPA

BL

−

T

Isense+Icomp

Icomp

## FIG 7

BL

PL

$R_C$

$V_{noise}$

$C_{cell}$

T

Kn

$C_{jctn}$
0.022fF

WL

GND

FIG 4

# FIG 5

EP 1 630 817 B1

# FIG 6

EP 1 630 817 B1

# FIG 8

WL1    WL2    WL3    WL4

A

BL

PL11
PL12
PL13
PL14

Puffer
Register

EP 1 630 817 B1

# FIG 9

WL Aktiv.

sequentiell PL-Aktiv.

10

11

12

13

14

15

I/O

I/O

. . .

EP 1 630 817 B1

## FIG 10

## FIG 11

**IN DER BESCHREIBUNG AUFGEFÜHRTE DOKUMENTE**

**In der Beschreibung aufgeführte Patentdokumente**

- WO 03098636 A2
- WO 020844705 A2

- WO 02084705 A2
- US 20040047219 A1